# EUROPEAN PATENT APPLICATION

(11) **EP 4 485 548 A1**
(43) Date of publication of application: **01.01.2025**
(21) Application number: 22943507.8
(22) Date of filing: 15.11.2022
(51) Int. Cl.: H01L 29/872, H01L 21/329, H01L 29/47, H01L 29/868

(54) **SCHOTTKY DIODE DEVICE AND MANUFACTURING METHOD THEREFOR**

(30) Priority: 25.05.2022 CN 202210575076; 25.05.2022 CN 202221291724 U
(71) Applicant: Hubei Jiufengshan Laboratory, Wuhan, Hubei 430070 (CN)
(72) Inventor: YUAN, Jun, Wuhan, Hubei 430070 (CN)
(74) Representative: Chung, Hoi Kan
(86) International application number: PCT/CN2022/131803
(87) International publication number: WO 2023/226320

(57) **Abstract**

The present application discloses a Schottky barrier diode device and a manufacturing method therefor. The Schottky barrier diode device comprises: an epitaxial wafer having an epitaxial layer, the epitaxial layer comprising a first surface and a second surface that are opposite to each other, and the first surface being provided with a functional region and trench regions located on both sides of the functional region; multi-level trenches located in the trench regions, a first ion implantation region being provided in the surface of the epitaxial layer exposed from the side wall and bottom of each of the multi-level trenches, each of the multi-level trenches comprising: multiple sub-trenches, the multiple sub-trenches successively comprising a first-level sub-trench to an N^{th}-level sub-trench in a first direction; the width of the sub-trenches in the same multi-level trench being sequentially increased in the first direction; the side wall of at least the first-level sub-trench being provided with a side wall protection structure; and a first metal electrode filling the multi-level trenches, the first metal electrode further covering the functional region of the first surface and being in Schottky contact with the functional region of the first surface.

## Description

### CROSS-REFERENCE TO RELATED APPLICATIONS

This application claims priority to Chinese Patent Application No. 202210575076.1, entitled "SCHOTTKY BARRIER DIODE DEVICE AND MANUFACTURING METHOD THEREFOR" filed on May 25, 2022 to China Patent Office, the entire contents of which are incorporated herein by reference.

This application claims priority to Chinese Patent Application No. 202221291724.2, entitled "SCHOTTKY BARRIER DIODE DEVICE AND MANUFACTURING METHOD THEREFOR" filed on May 25, 2022 to China Patent Office, the entire contents of which are incorporated herein by reference.

### TECHNICAL FIELD

The application relates to the field of semiconductor device technology, and more particularly, to a Schottky barrier diodes (SBD) device and a manufacturing method therefor.

### BACKGROUND

SiC is a kind of wide bandgap semiconductor material developed rapidly in recent ten years. Compared with other semiconductor materials (such as Si, GaN and GaAs), SiC has the advantages of wide bandgap, high thermal conductivity, high carrier saturation mobility and high power density. SiC can be thermally oxidized to form silicon dioxide, enabling the implementation of power devices and circuits such as SiC MOSFET and SBD. Since the 1990s, SiC MOSFET and SBD power devices have been widely used in switching power supply, high-frequency heating, automotive electronics and power amplifiers.

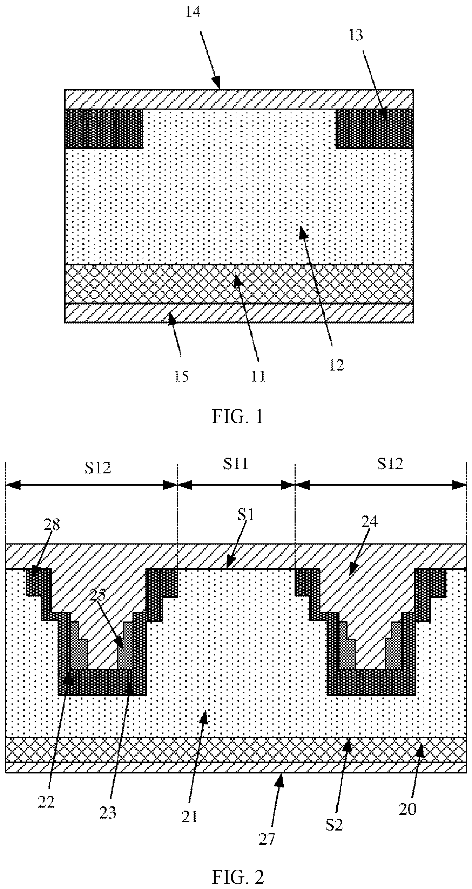

As shown in Fig. 1, Fig. 1 is a schematic structural diagram of a conventional SiC Schottky barrier diode device, including: a substrate 11, and an epitaxial layer 12 disposed on the substrate 11, wherein the surface of one side of the epitaxial layer 12 facing away from the substrate 11 includes a functional region and ion implantation regions 13 on two sides of the functional region; and the surface of a side of the epitaxial layer 12 facing away from the substrate 11 has an anode; and a thin film on a side of the substrate 11 facing away from the epitaxial layer 12 has a cathode. Typically, the epitaxial layer is N-doped SiC and the ion implantation region 13 is P+ doped (P-type heavily doped). With regard to the device structure shown in Fig. 1, especially a high-voltage SBD device, the optimal design of the breakdown voltage and the on-resistance are mutually influenced and contradictory. It is generally difficult to obtain a low on-resistance when obtaining a high breakdown voltage, especially for a planar JBS (high-voltage junction barrier Schottky barrier diode) device. In the high-voltage design, since the implantation depth of the P+ doped ion implantation region 13 is limited by process equipment, it is difficult to achieve P+ implantation with a junction depth of more than 1 um.

Although trench-type SBD structures enable deeper P+ implantation in the SiC epitaxial layer, the trench-type SBD structures tend to create high electric field regions at the bottom of the trench and premature breakdown and leakage problems at the trench corner locations at the bottom of the trench.

### SUMMARY

In view of the above, the application provides a Schottky barrier diode device and a manufacturing method therefor, with the solution provided as follows.

A Schottky barrier diode device comprises:
an epitaxial wafer having an epitaxial layer, wherein the epitaxial layer comprises a first surface and a second surface that are opposite to each other; the first surface is provided with a functional region and trench regions located on both sides of the functional region;
multi-level trenches located in the trench region, wherein a first ion implantation region is provided in the surface of the epitaxial layer exposed from the side wall and bottom of each of the multi-level trenches;
each of the multi-level trenches comprises multiple sub-trenches; the multiple sub-trenches successively comprises a first-level sub-trench to an N^{th}-level sub-trench in a first direction, and N is a positive integer greater than 1; the first direction is a direction in which the second surface points towards the first surface; the width of each of the sub-trenches in the same multi-level trench is sequentially increased in the first direction, and the side wall of at least the first-level sub-trench is provided with a side wall protection structure; and
a first metal electrode filling the multi-level trenches, wherein the first metal electrode further covers the functional region of the first surface and is in Schottky contact with the functional region of the first surface.

Preferably, in the above Schottky barrier diode device, the side wall protection structure has an opening for exposing the bottom of the multi-level trench; and
an ohmic contact structure located within the opening;
wherein the first metal electrode is electrically connected to the first ion implantation region at the bottom of the multi-level trench by the ohmic contact structure.

Preferably, in the above Schottky barrier diode device, the epitaxial layer is a SiC layer; and
the ohmic contact structure is a metal complex formed on the basis of the SiC layer.

Preferably, in the above Schottky barrier diode device, a height of the ohmic contact structure in the first direction is less than a height of the first-level sub-trench and less than a height of the side wall protection structure.

Preferably, in the above Schottky barrier diode device, a height of the side wall protection structure does not exceed a height of the first-level sub-trench in the first direction.

Preferably, in the above Schottky barrier diode device, the side wall protection structure is a SiO₂ layer, or a SiN layer.

Preferably, in the above Schottky barrier diode device, the epitaxial wafer comprises a semiconductor substrate and the second surface is disposed opposite to the semiconductor substrate;
wherein the surface of a side of the semiconductor substrate facing away from the epitaxial layer has a second metal electrode.

Preferably, in the above Schottky barrier diode device, the first surface has a second ion implantation region therein surrounding the opening of the multi-level trench, the second ion implantation region being in contact with the first ion implantation region;
wherein the second ion implantation region and the first ion implantation region are both inversely doped with the epitaxial layer.

The application also provides a manufacturing method for a Schottky barrier diode device, comprising:
providing an epitaxial wafer having an epitaxial layer, wherein the epitaxial layer comprises a first surface and a second surface that are opposite to each other; the first surface is provided with a functional region and trench regions located on both sides of the functional region;
forming multi-level trenches in the trench region, wherein each of the multi-level trenches comprises multiple sub-trenches; the multiple sub-trenches successively comprises a first-level sub-trench to an Nth-level sub-trench in a first direction, and N is a positive integer greater than 1; the first direction is a direction in which the second surface points towards the first surface; the width of each of the sub-trenches in the same multi-level trench is sequentially increased in the first direction;
forming a first ion implantation region in the surface of the epitaxial layer exposed from the side wall and bottom of each of the multi-level trenches;
forming a side wall protection structure at the side wall of at least the first-level sub-trench; and
forming a first-level metal electrode in the multi-level trench, wherein the first metal electrode further covers the functional region of the first surface and is in Schottky contact with the functional region of the first surface.

Preferably, in the above manufacturing method, the method for forming the side wall protection structure further comprises:
forming an insulating dielectric layer covering the side wall and bottom of the multi-level trench and covering a functional region of the first surface;
forming an opening in a region of the insulating dielectric layer corresponding to the bottom of the multi-level trench so as to expose a partial bottom region of the multi-level trench; and
removing the insulating dielectric layer on the first surface and a portion of the insulating dielectric layer in the multi-level trench, wherein the insulating dielectric layer remaining in the multi-level trench is the side wall protection structure.

Preferably, in the above manufacturing method, prior to the removing the insulating dielectric layer on the first surface and a portion of the insulating dielectric layer in the multi-level trench, the method further comprises:
forming a first metal layer at the bottom of the opening; and
forming the ohmic contact structure based on the first metal layer.

It can be seen from the above-mentioned description that the technical solution of the application provides a Schottky barrier diode device and a manufacturing method therefor. The Schottky barrier diode device comprises: an epitaxial wafer having an epitaxial layer, wherein the epitaxial layer comprises a first surface and a second surface that are opposite to each other; the first surface is provided with a functional region and trench regions located on both sides of the functional region; multi-level trenches located in the trench regions, wherein a first ion implantation region is provided in the surface of the epitaxial layer exposed from the side wall and bottom of each of the multi-level trenches; each of the multi-level trenches comprises multiple sub-trenches; the multiple sub-trenches successively comprises a first-level sub-trench to an N^{th}-level sub-trench in a first direction, and N is a positive integer greater than 1; the first direction is a direction in which the second surface points towards the first surface; the width of the sub-trenches in the same multi-level trench is sequentially increased in the first direction; the side wall of at least the first-level sub-trench is provided with a side wall protection structure; and a first metal electrode filling the multi-level trenches, wherein the first metal electrode further covers the functional region of the first surface and is in Schottky contact with the functional region of the first surface. The technical solution of the application solves the problem of premature breakdown and leakage easily occurring at the corner of the trench of the multi-level trench by providing the side wall protection structure.

### BRIEF DESCRIPTION OF DRAWINGS

In order to more clearly describe the technical solutions in the embodiments of the application or the prior art, the drawings to be used in the description of the embodiments or the prior art will be briefly introduced below. It will be apparent to those skilled in the art that the drawings in the following description are only some of the application, and that other drawings may be obtained from the drawings without any creative works.

It should be understood that the structure, proportion, size, etc. shown in the attached diagram of this specification are only for the understanding and reading of the person familiar with the technology, and are not for the limitation of the implementation of the invention. Thus, they have no technical significance. Any structural modification and change of proportion relationship or size adjustment, without affecting the effects that the invention can produce and the purposes that can be achieved, all shall still fall within the scope covered by the technical content disclosed by the invention.
Fig. 1 is a schematic structural diagram of a conventional SiC Schottky barrier diode device;
Fig. 2 is a schematic structural diagram of a Schottky barrier diode device according to an embodiment of the application;
Fig. 3 is a schematic structural diagram of a Schottky barrier diode device according to an embodiment of the application; and
Figs. 4-22 are process flow diagrams of a manufacturing method for a Schottky barrier diode device according to embodiments of the application.

### DETAILED DESCRIPTION OF THE EMBODIMENTS

The embodiments of the application will be described clearly and completely in conjunction with the accompanying drawings in the embodiments of the application. Obviously, the described embodiments are only part of the embodiments of the application, rather than all of the embodiments. Based on the embodiments in the application, all other embodiments obtained by a person skilled in the art without involving any inventive effort are within the scope of protection of the application.

The trench-type SBD structure is prone to generate a high electric field region at the bottom of the trench. Especially, if the bottom of the trench is in direct contact with a metal electrode, it is prone to generate a high electric field, resulting in premature breakdown or leakage of the device at the corner of the trench. The metal electrode is directly formed at the bottom of the groove and also easily forms a metal spike. Even with various attempts to make the trench smoother, there is still a problem with the high electric field at the bottom, making it difficult to produce reliable devices on a stable scale.

In view of this, the technical solution of the application provides a Schottky barrier diode device and a manufacturing method therefor, which can solve the problem of premature breakdown or leakage of the device at a trench corner of a multi-level trench caused by a high electric field by providing a side wall protection structure.

Further, an ohmic contact structure may be formed at the bottom of the multi-level trench such that the first metal electrode is electrically connected to the first ion implantation region via the ohmic contact structure. Thus, a composite fill structure is formed at the bottom of the multi-level trench to avoid direct contact of the first metal electrode with the bottom of the multi-level trench and to avoid leakage and breakdown problems of the device at the bottom of the multi-level trench due to the high electric field at the trench corner caused by the direct contact of the first metal electrode with the multi - level trench, thereby improving device reliability.

By providing an ohmic contact structure at the bottom of the multi-level trench, and providing a trench side wall protection structure at the side wall of the first-level sub-trench, it forms a composite filling on the bottom of the multi-level trench, which is not only able to avoid direct contact between the first metal electrode and the bottom of the multi-level trench, and enables the bottom of the first metal electrode to be surrounded by the side wall protection structure and the ohmic contact structure, so as to form a MOS capacitor structure. It does not affect the shielding of the first ion implantation region from the electric field of the Schottky region, and at the same time being able to alleviate the high electric field at the bottom of the multi-level trench, so as to avoid premature breakdown and leakage of the bottom of the multi-level trench and enhance the manufacturability and reliability of the device.

The above objects, features and advantages of the application can be more clearly understood from the following detailed description of the application taken in conjunction with the accompanying drawings and the detailed description.

As shown in Fig. 2, Fig. 2 is a schematic structural diagram of a Schottky barrier diode device according to an embodiment of the application. The Schottky barrier diode device shown comprises:
an epitaxial wafer having an epitaxial layer 21, wherein the epitaxial layer 21 has a first surface S1 and a second surface S2 that are opposite to each other; the first surface S1 is provided with a functional region S11 and trench regions S12 located on both sides of the functional region S11;
multi-level trenches 22 located in the trench region S12, wherein a first ion implantation region 23 is provided in the surface of the epitaxial layer exposed from the side wall and bottom of each of the multi-level trenches 22;
each of the multi-level trenches 22 comprises multiple sub-trenches; the multiple sub-trenches successively comprises a first-level sub-trench to an N^{th}-level sub-trench in a first direction (a direction from bottom to top in Fig. 2), and N is a positive integer greater than 1; the first direction is a direction in which the second surface S2 points towards the first surface S1; the width of each of the sub-trenches in the same multi-level trench 22 is sequentially increased in the first direction, and the side wall of at least the first-level sub-trench is provided with a side wall protection structure 25; and
a first metal electrode 24 filling the multi-level trenches 22, wherein the first metal electrode 24 further covers the functional region S11 of the first surface S1 and is in Schottky contact with the functional region S11 of the first surface S1. Herein, the contact surface of the first metal electrode 24 and the functional region S11 of the first surface S1 is a Schottky region.

In the embodiment of the application, multi-level trenches 22 are formed in the trench region S12, and deep trenches can be formed, thereby enabling the formation of a first ion implantation region 23 of greater depth within the epitaxial layer 21. When the epitaxial layer 21 is a SiC layer and the first ion implantation region 23 is a P+ doped ion implantation region, a greater depth of P+ ion implantation in the SiC material can be achieved without the need for high energy and high dose ion implantation without destroying the lattice structure of the SiC. In addition, providing the side wall of at least the first-level sub-trench with a side wall protection structure 25 enables effective protection against the bottom trench corner of the multi-level trench 22, and solves the problem of premature breakdown and leakage at the trench corner of the multi-level trench.

When the bottom of the multi-level trench 22 is in direct contact with the first metal electrode 24, a high electric field is easily generated to cause premature breakdown or leakage of the device at the trench corner, and the voltage resistance and leakage resistance of the trench corner region can be improved to some extent by providing the side wall protection structure 25.

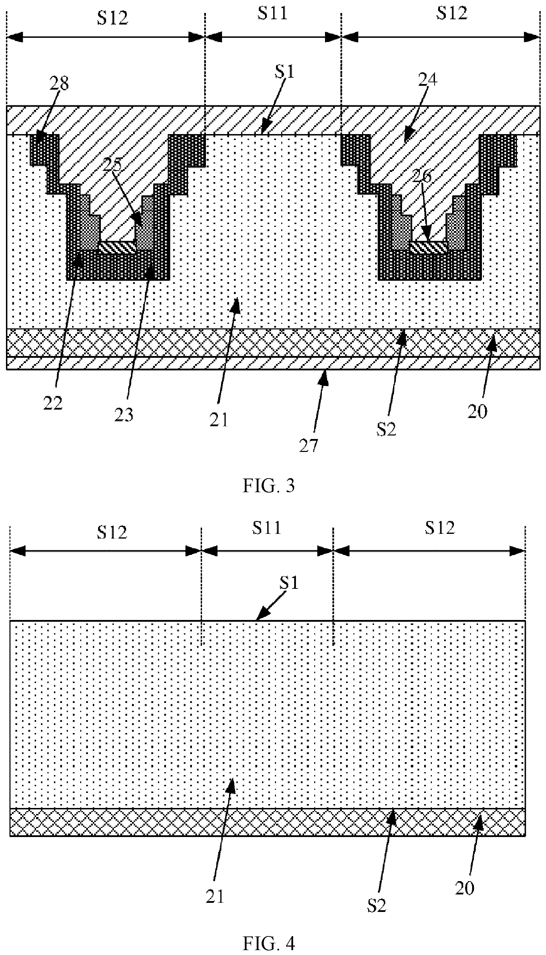

The Schottky barrier diode device may also be as shown in Fig. 3 in order to further enhance the device's voltage resistance and leakage resistance in the trench corner region.

As shown in Fig. 3, Fig. 3 is a schematic structural diagram of a Schottky barrier diode device according to an embodiment of the application. On the basis of the manner shown in Fig. 2, in the Schottky barrier diode device shown in Fig. 3, the side wall protection structure 25 has an opening for exposing the bottom of the multi-level trench 22; and an ohmic contact structure 26 located in the opening; wherein the first metal electrode 24 is electrically connected to the first ion implantation region 23 of the multi-level trench bottom 22 by the ohmic contact structure 25.

In the manner shown in Fig. 3, by providing an ohmic contact structure 26 at the bottom of the multi-level trench 22, and providing a trench side wall protection structure 25 at the side wall of the first-level sub-trench, it forms a composite filling on the bottom of the multi-level trench 22, which is not only able to avoid direct contact between the first metal electrode 24 and the bottom of the multi-level trench 22, and enables the bottom of the first metal electrode 24 to be surrounded by the side wall protection structure 25 and the ohmic contact structure 26, so as to form a MOS capacitor structure. It does not affect the shielding of the first ion implantation region 23 from the electric field of the Schottky region, and at the same time being able to alleviate the high electric field at the bottom of the multi-level trench 22, so as to avoid premature breakdown and leakage of the bottom of the multi-level trench 22 and enhance the manufacturability and reliability of the device.

In the embodiment of the application, the epitaxial layer 21 is a SiC layer. The ohmic contact structure 26 is a metal complex formed on the basis of the SiC layer 21. Using the metal complex as the ohmic contact structure 26 can effectively improve device performance, and enhance device manufacturability and reliability.

As shown in Fig. 3, in the first direction, the height of the ohmic contact structure 26 is set to be less than the height of the first-level sub-trench and less than the height of the side wall protection structure 25. Using a smaller thickness of the ohmic contact structure 26 can achieve that the bottom of the multi-level trench 22 meets filling requirements, reducing manufacturing costs and improving production efficiency.

In the Schottky barrier diode device according to the embodiment of the application, as shown in Figs. 2 and 3, the height of the side wall protection structure 25 does not exceed the height of the first-level sub-trench in the first direction.

Alternatively, the side wall protection structure 25 is a SiO₂ layer, or a SiN layer. The material of the side wall protection structure 25 may be selected based on requirements, which is not specifically limited in the embodiments of the application.

As shown in Figs. 2 and 3, the epitaxial wafer comprises a semiconductor substrate 20, the second surface S2 being arranged opposite to the semiconductor substrate 20; wherein the surface of a side of the semiconductor substrate 20 facing away from the epitaxial layer 21 has a second metal electrode 27. Herein, the first metal electrode 24 is an anode of a Schottky barrier diode device, and the second metal electrode 27 is a cathode of the Schottky barrier diode device.

As a result of the greater depth of the multi-level trench 22, the thickness of the first ion implantation region 23 in the second direction (horizontal in Fig. 2), which is parallel to the first surface S1, gradually decreases in the first direction. Especially in the vicinity of the opening of the multi-level trench 22, since the thickness of the first ion implantation region 23 is the thinnest, problems such as leakage and breakdown due to electric field concentration occur at this position, which affects the manufacturability and reliability of the device. In order to solve these problems, as shown in Figs. 2 and 3, in the Schottky barrier diode device, the epitaxial layer 21 has a second ion implantation region 28 surrounding the multi-level trench opening in the surface of the side facing away from the semiconductor substrate 20, the second ion implantation region 28 being in contact with the first ion implantation region 23. The second ion implantation region 28 may act as a voltage buffer to achieve voltage buffering in the opening region of the multi - level trench 22.

Herein, the second ion implantation region 28 and the first ion implantation region 23 are both inversely doped with the epitaxial layer 21. For example, the epitaxial layer 21 is an = N-(N-type lightly doped) epitaxial layer, and the second ion implantation region 28 and the first ion implantation region 23 may both be P+ ion implantation regions.

In the technical solution of the application, the voltage buffering of the opening region of the multi-level trench 22 is achieved by the second ion implantation region 28. With the multi-level trench structure, the contradiction between the forward conduction impedance of the device and the withstand voltage of the Schottky region and the reliability of the surface electric field caused by the single width trench can be avoided. The withstand voltage capability of the SBD device can be further enhanced while maintaining a low forward conduction impedance. The second ion implantation region 28 may enhance the process tolerance of the device, avoid leakage of the Schottky contact process near to the opening of the multi-level trench 22, and leakage or breakdown problems caused by electric field build-up, enhancing the manufacturability and reliability of the device.

Another embodiment of the application also provides a manufacturing method for a Schottky barrier diode device as shown in Figs. 4-22.

With reference to Figs. 4-22, Figs. 4-22 are process flow diagrams of a manufacturing method for a Schottky barrier diode device according to embodiments of the application. The method comprises the steps below.

Step S11: as shown in Fig. 4, an epitaxial wafer is provided having an epitaxial layer 21.

The epitaxial layer 21 has a first surface S1 and a second surface S2 opposite to each other. The first surface S1 has a functional region S11 and trench regions S12 on both sides of the functional region S11.

Herein, the epitaxial wafer has a substrate 20. The epitaxial layer 21 runs on the substrate 20, and the second surface S2 and the substrate 20 are oppositely arranged. The substrate 20 may be an N+ (N-type heavily doped) SiC substrate. The epitaxial layer 21 is an N- SiC epitaxial layer.

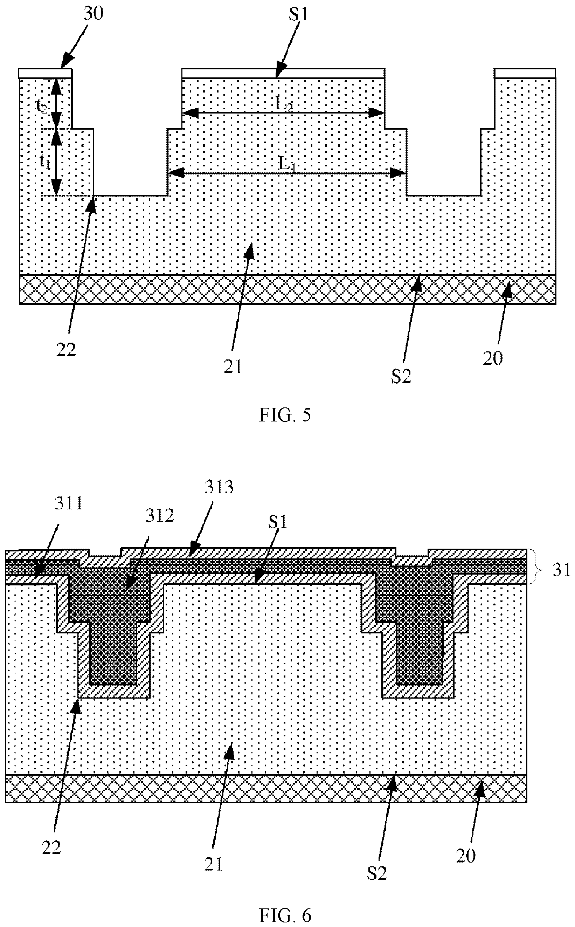

Step S12: as shown in Fig. 5, a multi-level trench 22 is formed in the trench region S12.

The multiple sub-trenches successively comprises a first-level sub-trench to an N^{th}-level sub-trench in a first direction, and N is a positive integer greater than 1. The first direction is a direction in which the second surface S2 points towards the first surface S1. The width of each of the sub-trenches in the same multi-level trench 22 is sequentially increased in the first direction.

The same multi-level trench 22 is set to have a first-level sub-trench to an N^{th}-level sub-trench in a first direction, where N is a positive integer greater than 1. The value of N may be set based on requirements, and this is not specifically defined in the application. In the embodiment of the application, N = 2 is exemplified, i.e., the multi-level trench 22 has two levels of trenches.

On both sides of the functional region S11, in two multi-level trenches 22, the spacing between the i^{th}-level sub-trenches is Lᵢ, where Lᵢ₋₁ is greater than Li, and i is a positive integer greater than 1 and not greater than N. Thus, in the same multi-level trench 22, the widths of the sub-trenches of each level decrease successively from top to bottom, and the value of Lᵢ may be set based on requirements, which is not specifically defined in the embodiments of the application. Taking N = 2 as an example, in the two multi-level trenches 22, the spacing between first-level sub-trenches is L1, the spacing between the second-level sub-trenches is L₂, and L₁ is greater than L₂. In the same multi-level trench 22, the depth of the first-level sub-trench is tᵢ. Taking N = 2 as an example, in the same multi-level trench 22, the depth of the first-level sub-trench is t₁, and the depth of the i^{th}-level sub-trench is t₂. The value of tᵢ can be set on the basis of requirements, and the embodiments of the application do not specifically define this.

The epitaxial wafer is subjected to two or more photolithography and etchings to form two or more levels of trenches. The epitaxial wafer needs to make alignment marks after entering the process line for the position alignment of the subsequent photolithography process. The technical solution of the application prepares a first-level sub-trench while fabricating the alignment mark, without adding an etching process separately. It reuses the etching process of the alignment mark to prepare the first-level sub-trench, thus reducing the manufacturing cost.

The multi-level trenches 22 may be formed based on the mask layer 30 disposed on the first surface S1. The manner in which the embodiments of the application correspond to the multi-level trench 22 is not particularly limited. After forming the multi-level trench 22, the mask layer 30 on the first surface S1 is removed.

Step S13: as shown in Figs. 6-11, a first ion implantation region 23 is formed in the surface of the epitaxial layer exposed from the side wall and bottom of each of the multi-level trenches 22.

Herein, the step S13 specifically comprises the content below.

First, as shown in Fig. 6, a sacrificial layer 31 including a first silicon dioxide layer 311, a polysilicon layer 312, and a second silicon dioxide layer 313 laminated in order is deposited on the first surface S1. Subsequent steps after patterning the sacrificial layer 31 may cause a masking structure for ion implantation. P-type doping of the SiC material typically employs high energy Al ion implantation, and the polysilicon layer 312 is capable of forming a post-ion implantation masking effect.

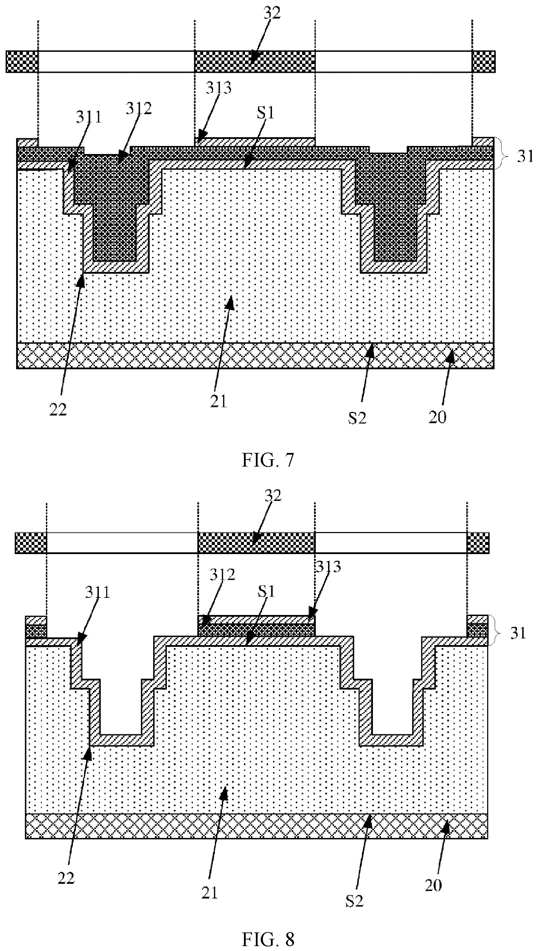

Then, as shown in Fig. 7, an opening is formed in the second silicon dioxide layer 313 by photolithography and dry etching to facilitate the subsequent formation of the first ion implantation region 23 by ion implantation. The etched silicon oxide is provided first. The second silicon dioxide layer 313 is etched with a gas having a good etching property for silicon oxide, such as a mixed gas of at least one of CF₄ or CHF₃, or CH₂F₂, or C₄F₈, with oxygen, nitrogen, or argon.. The etching stops at the surface of the polysilicon layer 312. The openings in the second silicon dioxide layer 313 are determined based on the metal pattern plate 32.

Further, as shown in Fig. 8, the polysilicon is used. It etches the polysilicon layer 312 with a high-selectivity etchant gas for the silicon oxide, such as a mixture of HBr and Ar.

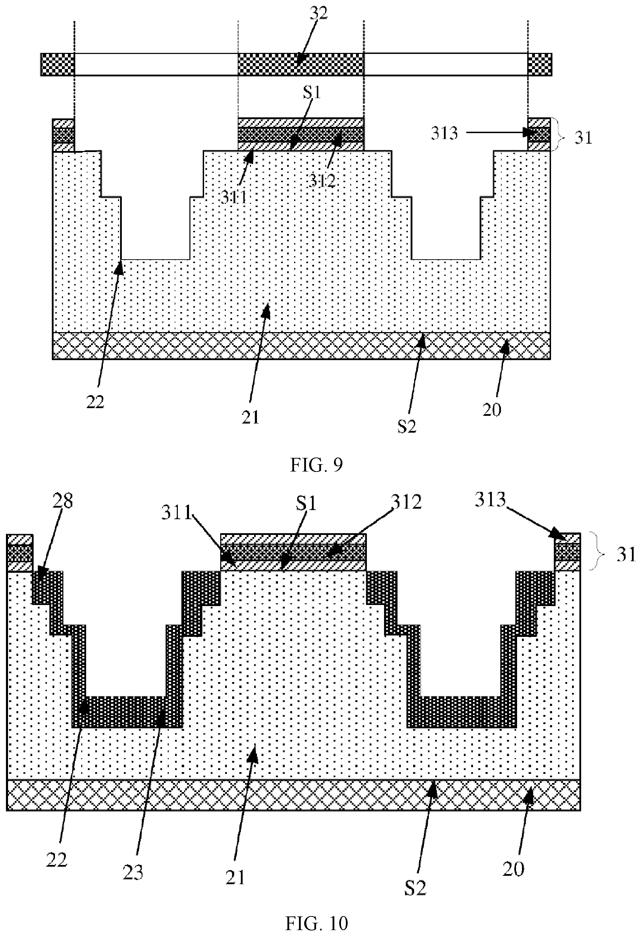

Further, as shown in Fig. 9, the first silicon dioxide layer 311 is etched with a gas having a good etching property for silicon oxide, such as a mixed gas of at least one of CF₄ or CHF₃, or CH₂F₂, or C₄F₈, with oxygen, nitrogen, or argon. Alternatively, the first silicon dioxide layer 311 is etched away using an F-based gas such as CHF₃, CF₄, or the like.

Further, as shown in Fig. 10, P ion implantation is performed on the side walls and bottom of the multi-level trench 22 based on the patterned sacrificial layer 31 to form a first ion implantation region 23, where the implanted ions are preferably Al ions.

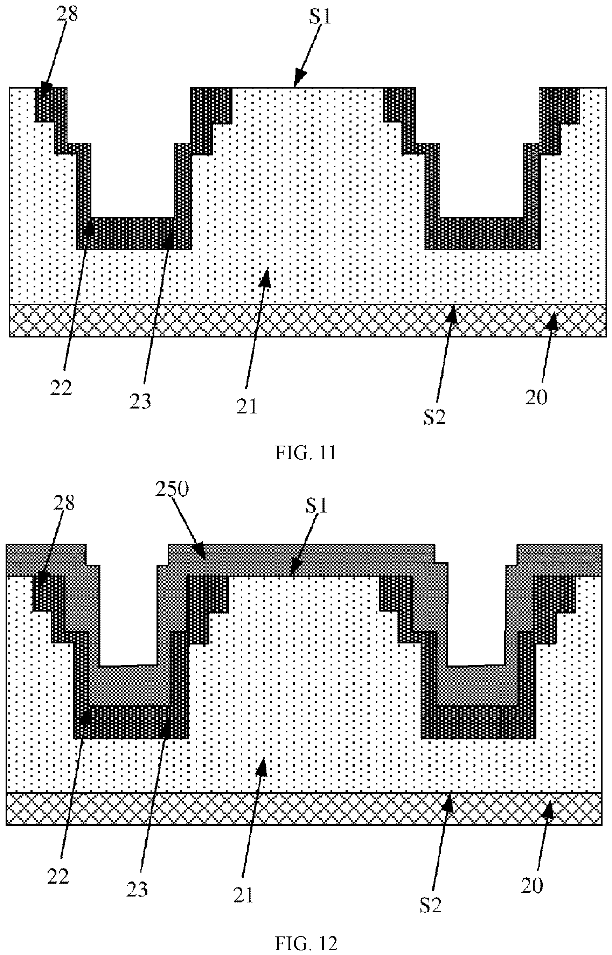

Finally, as shown in Fig. 11, the remaining sacrificial layer 31 is removed. Alternatively, the first surface S1 is removed using a dry etch and wet etch process to remove the remaining sacrificial layer 31.

Optionally, after forming the first ion implantation region 23 and before forming the side wall protection structure 25, the manufacturing method further comprises that the ion implantation region is subjected to annealing activation and lattice repair. The implanted-P-type ions such as Al ions are annealed and lattice repaired in a high temperature furnace tube at 1500°C-1900°C for 10 minutes -30 minutes using a carbon film protection commonly used in silicon carbide device processes.

By arranging the pattern structure of the sacrificial layer 31 such that the ion implantation window is larger than the opening of the multi-level trench 22 at the first surface S1 and a portion of the first surface S1 of the multi-level trench 22 around the opening of the first surface S1 is exposed, it is possible to simultaneously form the second ion implantation region 28 on the first surface S1 while performing ion implantation to form the first ion implantation region 23.

Step S14: as shown in Figs. 12-22, a side wall protection structures 25 is formed at the side wall of at least the first-level sub-trench.

The step S14 includes the steps below. An insulating dielectric layer is formed covering the side wall and bottom of the multi-level trench and covering a functional region of the first surface. An opening is formed in a region of the insulating dielectric layer corresponding to the bottom of the multi-level trench so as to expose a partial bottom region of the multi-level trench. The insulating dielectric layer on the first surface and a portion of the insulating dielectric layer in the multi-level trench are removed wherein the insulating dielectric layer remaining in the multi-level trench is the side wall protection structure.

Prior to the removing the insulating dielectric layer on the first surface and a portion of the insulating dielectric layer in the multi-level trench, the method further comprises the steps below. A first metal layer is formed at the bottom of the opening. The ohmic contact structure is formed based on the first metal layer.

Specifically, the implementation method of step S14 comprises:

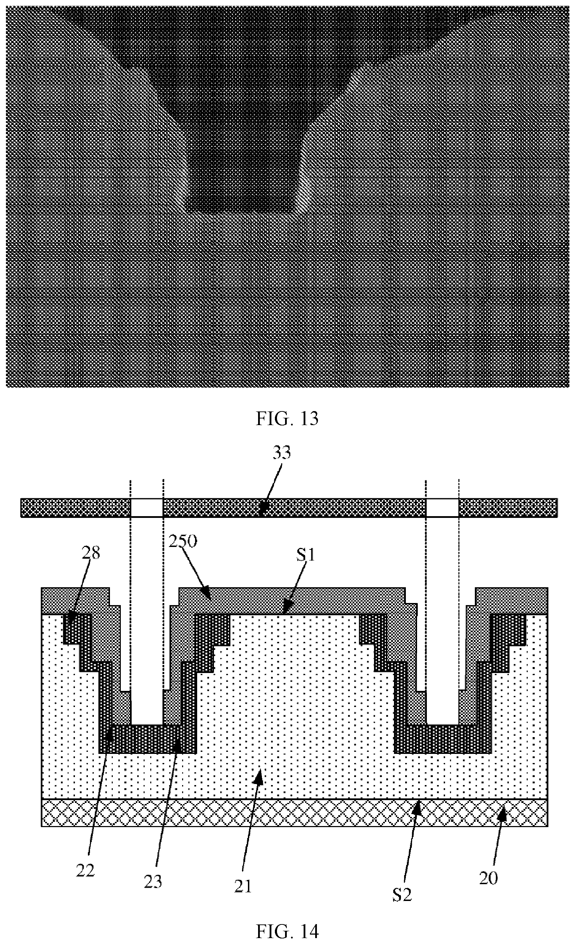

First, as shown in Fig. 12, an insulating dielectric layer 250 is formed. The insulating dielectric layer is SiO₂ or SiN. An insulating dielectric layer 250 covers the first surface S1 and the side wall and bottom of the multi-level trench 22. The insulating dielectric layer 250 can be prepared using a CVD process or a LPCVD process, and the insulating dielectric layer 250 can be formed with good trench step coverage. As shown in Fig. 13, Fig. 13 is a SEM diagram of a multi-level trench 22 covered with an insulating dielectric layer 250. It can be seen from Fig. 13 that an insulating dielectric layer 250 having good trench step coverage can be formed on the surface of the multi-level trench 22.

Then, as shown in Fig. 14, an opening is formed in the insulating dielectric layer 250 corresponding to the bottom of the multi-level trench 22 to expose a partial bottom region of the multi-level trench 22. The insulating dielectric layer 250 at the bottom of the multi-level trench 22 may be opened by photolithography and etching to facilitate subsequent processing to form the ohmic contact structure 26. Openings may be formed in the insulating dielectric layer 250 based on the metal pattern plate 33. When the insulating dielectric layer 250 is opened, the etching depth of the underlying epitaxial layer 21 does not exceed 500 nm.

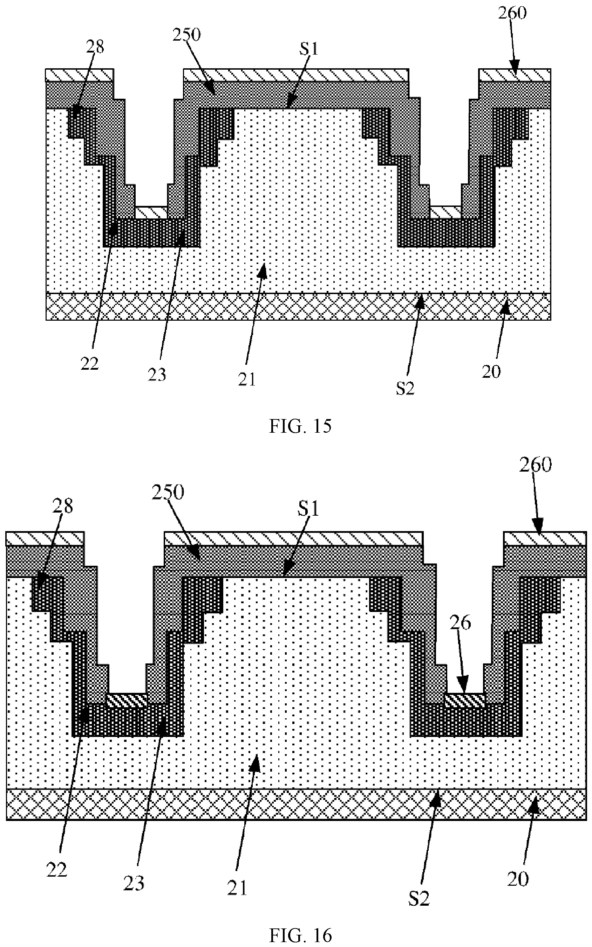

Further, as shown in Fig. 15, a metal layer 260 is deposited covering the surface of the side of the insulating dielectric layer 250 facing away from the epitaxial wafer and covering the bottom of the multi-level trench 22 exposed by the insulating dielectric layer 250. The metal layer 260 may be formed using a PVD or evaporation process. The metal layer 260 is a material capable of undergoing a complexation reaction with SiC to form a good ohmic contact, such as Ni.

Further, as shown in Fig. 16, after forming the metal layer 260, by a rapid annealing process (RTA), such as a RTA annealing at 800-1100°C for 30 seconds -5 minutes, a metal silicide reaction occurs on the portion of the metal layer 260 at the bottom of the trench which is in contact with the silicon carbide to form a metal complex which is converted into the ohmic contact structure 26. The metal layer 260 on the surface of the insulating dielectric layer 250 does not undergo a metal silicide reaction due to the isolation of the insulating dielectric layer 250. In an embodiment of the application, the ohmic contact structure is a metal silicide.

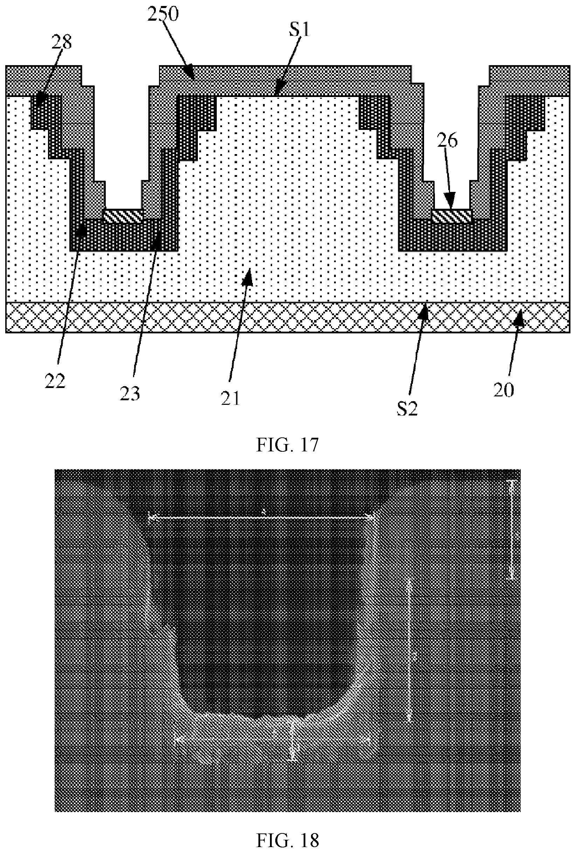

Further, as shown in Fig. 17, a dry etch, or a wet etch, such as a Ni etch solution, etc. is used to etch away the metal layer 260 that has not undergone the metal silicide reaction, leaving only the ohmic contact structure 26 at the bottom of the trench. As shown in Fig. 18, Fig. 18 is a SEM diagram after forming an ohmic contact structure 26. As can be seen from Fig. 18, a good ohmic contact effect may be formed.

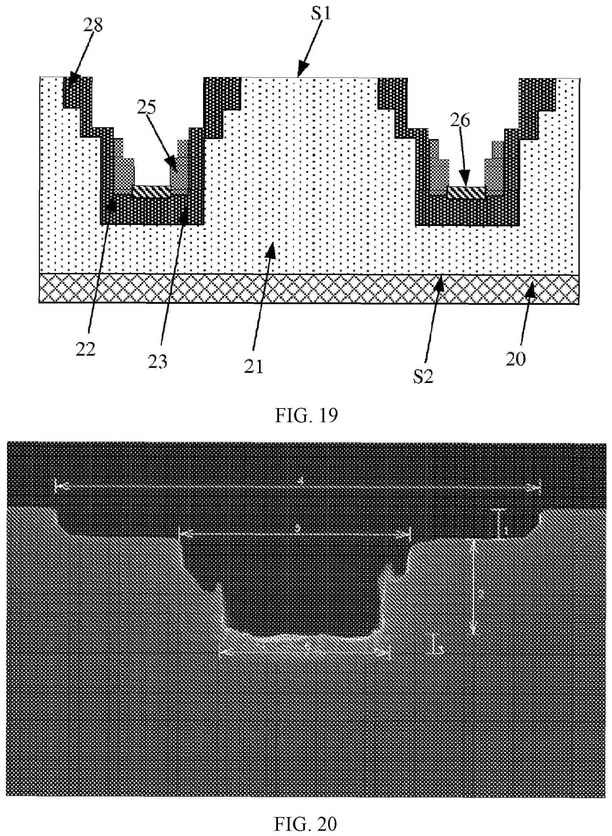

Finally, as shown in Fig. 19, an etching method such as a combination of dry etching and wet etching is used to remove the insulating dielectric layer 250 in the planar region above the first surface and remove the insulating dielectric layer 250 in the multi-level trench 22 near to the opening region, leaving at least the insulating dielectric layer 250 on the side wall of the first-level sub-trench. The insulating dielectric layer 250 may be etched to form the side wall protection structure 25 using a spacer ring formation method in a CMOS process. As shown in Fig. 20, Fig. 20 is a SEM diagram after forming a side wall protection structure 25. It can be seen from Fig. 20 that a side wall protection structure 25 with a good appearance can be formed at the bottom of a multi-level trench.

It should be noted that the degree of etching of the insulating dielectric layer 250 in the multi-level trench 22 may be controlled to form side wall protection structures 25 of different coverage, not limited to covering only the side walls of the first level trench, but also covering the side walls of other sub-trenches or step structures above it.

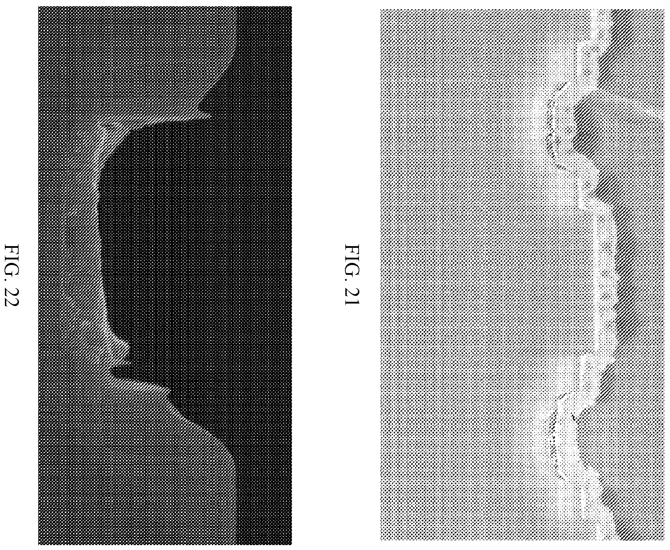

Step S15: A first-level metal electrode 24 is formed in the multi-level trench. The first metal electrode 24 also covers the functional region S11 of the first surface S1, and has a Schottky contact with the functional region S11 of the first surface S1, finally forming a Schottky barrier diode device as shown in Fig. 3. As shown in Fig. 21, Fig. 21 is a SEM diagram of a final Schottky barrier diode device formed using a manufacturing method according to an embodiment of the application.

In step S15, a process such as PVD or evaporation may be used to form the first metal electrode 24 on the first surface S1 and the second metal electrode 27 on the lower surface of the semiconductor substrate 20. The first metal electrode 24 may be a composite metal layer structure formed of two or more metals such as Ti, or Al, or Ti/TiW/Mo/Pt/Al. The first metal electrode 24 forms a non-ohmic contact with the side walls of the multi-level trench 22 and forms an ohmic contact at the bottom of the multi-level trench 22. The first metal electrode 24 needs to be subjected to a RTA process to form a Schottky contact with the functional region S11. After forming the first metal electrode 24, an electrode metal material can be deposited by a process such as PVD and etched to form a pad, wherein the metal material can be a composite metal layer structure formed by two or more metals such as Ti, or Al, or Ti/TiW/Mo/Pt/Al.

The manufacturing method described above is exemplified by fabricating the device structure shown in Fig. 3. Obviously, corresponding to the device structure shown in Fig. 2, the method for manufacturing same may be obtained with reference to the above-mentioned process flow, and the description thereof will not be repeated in the embodiments of the application.

In the embodiment of the application, it is not limited to the preparation of a multi-level trench in the trench region S12, but a single-stage trench may be used. As shown in Fig. 22, Fig. 22 is a SEM diagram of a single level trench-forming ohmic contact structure and a side wall protection structure.

It can be seen from the above-mentioned description that the manufacturing method described in the technical solution of the embodiments of the application can form a cell structure of a multi-step trench junction barrier diode with a bottom corner spacer protection. By constructing a multi-level trench junction barrier Schottky barrier diode device design with a side wall protection structure in a silicon carbide SBD device cell, reliability problems such as leakage and breakdown caused by the high electric field at the trench bottom of a trench JBS device due to the metal layer directly contacting the trench bottom with the trench corner can be avoided. It is beneficial to enhance the reliability of trench devices by providing side wall protection of dielectric layer structure on the bottom trench corners of multi-level trench JBS to avoid direct contact between metal and trench corners where strong electric field gathers at the bottom of trench. The metal layer filled in the trench and the side wall protection structure form a MOS capacitor structure, which does not affect the shielding of the P-type region from the electric field of the Schottky region, and at the same time can alleviate the high electric field of the relatively fragile trench corner of the bottom trench. It avoids the occurrence of premature breakdown and leakage at the bottom, and enhance the manufacturability and reliability of the device.

Various embodiments are described in this description in a progressive or parallel manner, or progressive and parallel combination, with each embodiment focusing on differences from the other embodiments, and with reference to the same or similar parts of the various embodiments.

It is noted that in the description of the application, it is to be understood that the drawings and description of the embodiments are illustrative and not restrictive. Like reference numerals refer to like structures throughout the embodiments of the description. In addition, the figures may be exaggerated in the thickness of layers, films, panels, regions, etc. for understanding and ease of description. It will also be understood that when an element such as a layer, film, region or substrate is referred to as being "on" another element, it can be directly on the other element or intervening elements may be present. Further, "on" refers to positioning an element on or under another element, but does not inherently refer to positioning on an upper side of another element depending on the direction of gravity.

The directional or positional relationships indicated by the terms "upper", "lower", "top","bottom","inner", "outer" and the like are based on the directional or positional relationships shown in the drawings. It is merely for the purpose of describing the application and simplifying the description, and is not intended to indicate or imply that a particular orientation, configuration and operation of the referenced device or element is required and should not be construed as limiting the application. When an element is referred to as being "connected" to another element, it can be directly connected to the other element or intervening elements may also be present.

It should be noted that relational terms such as first and second, and the like, may be used herein to distinguish one entity or action from another entity or action without necessarily requiring or implying any such actual relationship or order between such entities or actions. Furthermore, the terms "comprises", "comprising", or any other variation thereof, are intended to cover a non-exclusive inclusion, such that an article, or an apparatus that includes a list of elements does not include only those elements but may include other elements not expressly listed or inherent to such article or apparatus. An element proceeded by the phrase "comprising a" does not, without more constraints, preclude the existence of additional identical elements in the article or apparatus that includes the element.

The previous description of the disclosed embodiments is provided to enable any person skilled in the art to make or use the application. Various modifications to these embodiments will be readily apparent to those skilled in the art. The generic principles defined herein may be implemented in other embodiments without departing from the spirit or scope of the application. Thus, the application is not intended to be limited to the embodiments shown herein but accords with the widest scope consistent with the principles and novel features disclosed herein.

## Claims

1. A Schottky barrier diode device, comprising:
an epitaxial wafer having an epitaxial layer, wherein the epitaxial layer comprises a first surface and a second surface that are opposite to each other; the first surface is provided with a functional region and trench regions located on both sides of the functional region;
multi-level trenches located in the trench region, wherein a first ion implantation region is provided in the surface of the epitaxial layer exposed from the side wall and bottom of each of the multi-level trenches;
each of the multi-level trenches comprises multiple sub-trenches; the multiple sub-trenches successively comprises a first-level sub-trench to an N^{th}-level sub-trench in a first direction, and N is a positive integer greater than 1; the first direction is a direction in which the second surface points towards the first surface; the width of each of the sub-trenches in the same multi-level trench is sequentially increased in the first direction, and the side wall of at least the first-level sub-trench is provided with a side wall protection structure; and
a first metal electrode filling the multi-level trenches, wherein the first metal electrode further covers the functional region of the first surface and is in Schottky contact with the functional region of the first surface.

2. The Schottky barrier diode device according to claim 1, wherein the side wall protection structure has an opening for exposing the bottom of the multi-level trench; and
an ohmic contact structure located within the opening;
wherein the first metal electrode is electrically connected to the first ion implantation region at the bottom of the multi-level trench by the ohmic contact structure.

3. The Schottky barrier diode device according to claim 2, wherein the epitaxial layer is a SiC layer; and
the ohmic contact structure is a metal complex formed on the basis of the SiC layer.

4. The Schottky barrier diode device according to claim 2, wherein a height of the ohmic contact structure in the first direction is less than a height of the first-level sub-trench and less than a height of the side wall protection structure.

5. The Schottky barrier diode device according to claim 1, wherein a height of the side wall protection structure does not exceed a height of the first-level sub-trench in the first direction.

6. The Schottky barrier diode device according to claim 1, wherein the side wall protection structure is a SiO₂ layer, or a SiN layer.

7. The Schottky barrier diode device according to claim 1, wherein the epitaxial wafer comprises a semiconductor substrate and the second surface is disposed opposite to the semiconductor substrate;
wherein the surface of a side of the semiconductor substrate facing away from the epitaxial layer has a second metal electrode.

8. The Schottky barrier diode device according to any of claims 1-7, wherein the first surface has a second ion implantation region therein surrounding the opening of the multi-level trench, the second ion implantation region being in contact with the first ion implantation region;
wherein the second ion implantation region and the first ion implantation region are both inversely doped with the epitaxial layer.

9. A manufacturing method for a Schottky barrier diode device, comprising
providing an epitaxial wafer having an epitaxial layer, wherein the epitaxial layer comprises a first surface and a second surface that are opposite to each other; the first surface is provided with a functional region and trench regions located on both sides of the functional region;
forming multi-level trenches in the trench region, wherein each of the multi-level trenches comprises multiple sub-trenches; the multiple sub-trenches successively comprises a first-level sub-trench to an N^{th}-level sub-trench in a first direction, and N is a positive integer greater than 1; the first direction is a direction in which the second surface points towards the first surface; the width of each of the sub-trenches in the same multi-level trench is sequentially increased in the first direction;
forming a first ion implantation region in the surface of the epitaxial layer exposed from the side wall and bottom of each of the multi-level trenches;
forming a side wall protection structure at the side wall of at least the first-level sub-trench; and
forming a first-level metal electrode in the multi-level trench, wherein the first metal electrode further covers the functional region of the first surface and is in Schottky contact with the functional region of the first surface.

10. The manufacturing method according to claim 8, wherein the method for forming the side wall protection structure further comprises:
forming an insulating dielectric layer covering the side wall and bottom of the multi-level trench and covering a functional region of the first surface;
forming an opening in a region of the insulating dielectric layer corresponding to the bottom of the multi-level trench so as to expose a partial bottom region of the multi-level trench; and
removing the insulating dielectric layer on the first surface and a portion of the insulating dielectric layer in the multi-level trench, wherein the insulating dielectric layer remaining in the multi-level trench is the side wall protection structure.

11. The manufacturing method according to claim 10, prior to the removing the insulating dielectric layer on the first surface and a portion of the insulating dielectric layer in the multi-level trench, the method further comprises:
forming a first metal layer at the bottom of the opening; and
forming the ohmic contact structure based on the first metal layer.
